(19) Europäisches Patentamt

European Patent Office

Office européen des brevets

(11) **EP 4 545 989 A1**

(12) **EUROPEAN PATENT APPLICATION**

(43) Date of publication:
**30.04.2025 Bulletin 2025/18**

(21) Application number: **24186878.5**

(22) Date of filing: **05.07.2024**

(51) International Patent Classification (IPC):
**G01R 31/367** (2019.01)       **G01R 31/374** (2019.01)
**G01R 31/382** (2019.01)       **G01R 31/3835** (2019.01)

(52) Cooperative Patent Classification (CPC):
**G01R 31/374; G01R 31/382; G01R 31/3835;**
H01M 10/486

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **26.10.2023 KR 20230145068**

(71) Applicant: **SAMSUNG SDI CO., LTD.**
**Giheung-gu**
**Yongin-si, Gyeonggi-do**
**17084 (KR)**

(72) Inventor: **KANG, Kyungdo**
**17084 Yongin-Si (KR)**

(74) Representative: **Marks & Clerk LLP**
**15 Fetter Lane**
**London EC4A 1BW (GB)**

(54) **METHOD AND SYSTEM FOR CALCULATING BATTERY STATE OF CHARGE**

(57)     A method of calculating a state of charge of a battery, includes: calculating, by at least one processor, a state of charge (SOC) of a battery; obtaining, by the at least one processor, a temperature of the battery; calculating, by the at least one processor, based on the obtained temperature, a plurality of temperatures associated with a plurality of SOCs of the battery that are gradually downgraded from the calculated SOC of the battery by a grade; determining, by the at least one processor, based on the calculated plurality of temperatures, a specific SOC associated with a discharge end point of the battery; and determining, by the at least one processor, based on the determined specific SOC, a change trend of the SOC of the battery.

FIG. 1

EP 4 545 989 A1

**Description**

**BACKGROUND**

**1. Field**

Aspects of embodiments of the present disclosure relate to a method of calculating a state of charge of a battery.

**2. Description of the Related Art**

Unlike primary batteries that are not designed to be (re)charged, secondary batteries (or rechargeable batteries) are batteries that are designed to be discharged and recharged. Low-capacity secondary batteries are used in portable, small electronic devices, such as smart phones, feature phones, notebook computers, digital cameras, and camcorders. Large-capacity secondary batteries are widely used as a power source for driving motors in hybrid vehicles and electric vehicles, and/or for storing power (e.g., a home and/or utility scale power storage).

Because batteries may have a limited amount of runtime, it may be desirable to have accurate information related to a state of charge (SOC) of the batteries. As such, the SOC of a battery may be calculated by predicting changes in the SOC of the battery according to a voltage change in the battery, and on the basis of a lookup table including predicted result data. However, in a case where a temperature of the battery changes rapidly, there may be a difference between the calculated SOC and the actually available SOC.

The above information disclosed in this Background section is for enhancement of understanding of the background of the present disclosure, and therefore, it may contain information that does not constitute prior art.

**SUMMARY**

Embodiments of the present disclosure may be directed to a method and a system for calculating an actually available state of charge (SOC) of a battery on the basis of a changing temperature of the battery.

However, the aspects and features of the present disclosure are not limited thereto, and other aspects and features of the present disclosure may be understood by those having ordinary sill in the art from the description that follows.

According to one or more embodiments of the present disclosure, a method of calculating a state of charge of a battery, includes: calculating, by at least one processor, a state of charge (SOC) of a battery; obtaining, by the at least one processor, a temperature of the battery; calculating, by the at least one processor, based on the obtained temperature, a plurality of temperatures associated with a plurality of SOCs of the battery that are gradually downgraded from the calculated SOC of the battery by a grade; determining, by the at least one processor, based on the calculated plurality of temperatures, a specific SOC associated with a discharge end point of the battery; and determining, by the at least one processor, based on the determined specific SOC, a change trend of the SOC of the battery.

In an embodiment, the method may further include: obtaining, by the at least one processor, a voltage of the battery after the determining of the change trend of the SOC; and calculating, by the at least one processor, an SOC to be output based on the obtained voltage of the battery and the change trend of the SOC.

In an embodiment, the method may further include: determining, by the at least one processor, based on the determined specific SOC, a range of available SOCs after the determining of the change trend of the SOC; determining, by the at least one processor, based on the range of available SOCs, a discharge ratio of the battery; obtaining, by the at least one processor, a voltage of the battery; and calculating, by the at least one processor, based on the obtained voltage of the battery and the discharge ratio of the battery, an SOC to be output.

In an embodiment, the calculating of the plurality of temperatures may include calculating, by the at least one processor, the plurality of temperatures associated with the plurality of SOCs that are gradually downgraded based on a table including temperature changes according to an amount of energy change.

In an embodiment, the determining of the specific SOC associated with the discharge end point may include determining, by the at least one processor, based on the calculated plurality of temperatures, an SOC that exceeds a threshold temperature as the specific SOC associated with the discharge end point.

In an embodiment, the calculating of the plurality of temperatures may include: calculating, by the at least one processor, a first temperature associated with a first SOC that is downgraded from the calculated SOC of the battery by the grade; and calculating, by the at least one processor, a second temperature associated with a second SOC that is downgraded from the first SOC by the grade.

In an embodiment, the calculating of the first temperature may include: calculating, by the at least one processor, based on the first SOC, a voltage, a current, and a resistance; and calculating, by the at least one processor, the first temperature based on the obtained temperature of the battery, the calculated voltage, the calculated current, and the calculated resistance.

In an embodiment, the calculating of the first temperature may include: calculating, by the at least one processor,

$$\Delta T_i = \frac{3600 \times Q_{max} \times \Delta S}{100} \times (k \times I \times R)$$

an amount of temperature change in the first SOC according to ; and calculating, by the at least one processor, based on the calculated amount of temperature change, the first temperature. Here, $\Delta T_i$ may be the amount of temperature change associated with an SOC downgraded by an i grade, $Q_{max}$ may be a maximum capacity of the battery, $\Delta S$ may be an amount of SOC change, k may be a temperature coefficient, I may be a current, and R may be a resistance.

In an embodiment, the calculating of the first temperature may include calculating, by the at least one processor,

$$k = \frac{dT}{I^2 \times (\frac{ESR}{p}) \times dt}$$

the temperature coefficient according to . Here, k may be the temperature coefficient, dT may be a temperature change, I may be a current, p may be a number of battery cells, dt may be a time change, and ESR may be an equivalent resistance.

In an embodiment, the determining of the specific SOC associated with the discharge end point may include: determining, by the at least one processor, based on the calculated plurality of temperatures, whether or not the temperature of the battery exceeds a threshold temperature before a voltage of the battery is equal to or lower than a final discharge voltage; and if the temperature of the battery is determined to exceed the threshold temperature before the voltage of the battery is equal to or lower than the final discharge voltage, determining, by the at least one processor, an SOC associated with the temperature exceeding the threshold temperature to be the specific SOC associated with the discharge end point.

In an embodiment, the determining of the change trend of the SOC may include, if the SOC associated with the temperature exceeding the threshold temperature is determined to be the specific SOC associated with the discharge end point, determining, by the at least one processor, the change trend of the SOC so that a range of available SOCs may be reduced.

In an embodiment, the determining of the change trend of the SOC may include, if the SOC associated with the temperature exceeding the threshold temperature is determined to be the specific SOC associated with the discharge end point, determining, by the at least one processor, the change trend of the SOC so that an SOC change rate associated with the discharge may be more rapid.

In an embodiment, the determining of the SOC associated with the temperature exceeding the threshold temperature may include: calculating, by the at least one processor, a plurality of voltages associated with the plurality of SOCs of the battery that are gradually downgraded from the calculated battery SOC by the grade; determining, by the at least one processor, based on the calculated voltages, an SOC associated with the final discharge voltage at which the voltage of the battery is equal to or lower than the final discharge voltage; and if the temperature of the battery is determined to not exceed the threshold temperature before the voltage of the battery is equal to or lower than the final discharge voltage, determining, by the at least one processor, the SOC associated with the final discharge voltage to be the specific SOC associated with the discharge end point.

In an embodiment, a non-transitory computer-readable recording medium may include instructions executable by the at least one processor to perform the method.

According to one or more embodiments of the present disclosure, a battery management system includes: at least one processor; and memory including at least one computer-readable program executable by the at least one processor to cause the at least one processor to: calculate a state of charge (SOC) of a battery; obtain a temperature of the battery; calculate, based on the obtained temperature, a plurality of temperatures associated with a plurality of SOCs of the battery that are gradually downgraded from the calculated SOC of the battery by a grade; determine, based on the calculated plurality of temperatures, a specific SOC associated with a discharge end point of the battery; and determine, based on the determined specific SOC, a change trend of the SOC.

In an embodiment, the at least one program may further cause the at least one processor to: obtain a voltage of the battery; and based on the obtained voltage of the battery and the change trend of the SOC, calculate an SOC to be output.

In an embodiment, the at least one program may further cause the at least one processor to: determine, based on the determined specific SOC, a range of available SOCs; determine, based on the range of available SOCs, a discharge ratio of the battery; obtain a voltage of the battery; and based on the obtained voltage of the battery and the discharge ratio of the battery, calculate an SOC to be output.

In an embodiment, to calculate the plurality of temperatures, the at least one program may further cause the at least one processor to: calculate a first temperature associated with a first SOC downgraded from the calculated SOC of the battery by the grade; and calculate a second temperature associated with a second SOC downgraded from the first SOC by the grade.

In an embodiment, to determine the specific SOC associated with the discharge end point, the at least one program may further cause the at least one processor to: determine, based on the calculated temperatures, whether or not the temperature of the battery exceeds a threshold temperature before a voltage of the battery is equal to or lower than a final discharge voltage; and if the temperature of the battery is determined to exceed the threshold temperature before the voltage of the battery is equal to or lower than the final discharge voltage, determine an SOC associated with the temperature exceeding the threshold temperature to be the specific SOC associated with the discharge end point.

In an embodiment, to determine the change trend of the SOC, the at least one program may further cause the at least one processor to, if the SOC associated with the temperature exceeding the threshold temperature is determined to be the specific SOC associated with the discharge end point, determine the change trend of the SOC so that an SOC change rate associated with the discharge is more rapid.

According to some embodiments of the present disclosure, changes in the temperature of a battery may be predicted, and actually available SOCs may be calculated and output on the basis of the predicted changes in the temperature. Accordingly, at a discharge end point of the battery at which the temperature of the battery reaches a threshold temperature, a phenomenon in which the SOC of the battery is displayed as still being available may be reduced.

According to some embodiments of the present disclosure, by performing a control so that the SOC of the battery is displayed as little or none (e.g., 0) at a time point at which the battery is discharged according to the temperature change, a degree of satisfaction of use of the battery may be improved.

According to some embodiments of the present disclosure, changes in the temperature of the battery may be accurately predicted by predicting the temperature of the battery on the basis of an amount of energy change.

At least some of the above and other features of the invention are set out in the claims.

However, the aspects and features of the present disclosure are not limited to those described above, and additional aspects and features will be set forth, in part, in the detailed description that follows with reference to the figures, and in part, may be apparent therefrom, or may be learned by practicing one or more of the presented embodiments of the present disclosure.

## BRIEF DESCRIPTION OF THE DRAWINGS

The above and other aspects and features of the present disclosure will be more clearly understood from the following detailed description of the illustrative, non-limiting embodiments with reference to the accompanying drawings.

FIG. 1 illustrates a block diagram showing a schematic configuration of a battery management system, according to one or more embodiments of the present disclosure.

FIG. 2 illustrates a block diagram showing an internal configuration of a processor, according to one or more embodiments of the present disclosure.

FIG. 3 is a graph illustrating a temperature change trend according to an amount of energy change, according to one or more embodiments of the present disclosure.

FIG. 4 is a graph illustrating an example of a voltage change trend and a temperature change trend of a battery, according to one or more embodiments of the present disclosure.

FIG. 5 is a graph illustrating another example of a voltage change trend and a temperature change trend of a battery, according to one or more embodiments of the present disclosure.

FIG. 6 is a graph illustrating another example of a voltage change trend and a temperature change trend of a battery, according to one or more embodiments of the present disclosure.

FIG. 7 is a graph illustrating another example of a voltage change trend and a temperature change trend of a battery, according to one or more embodiments of the present disclosure.

FIG. 8 is a graph illustrating an example of a fluctuating SOC change trend, according to one or more embodiments of the present disclosure.

FIG. 9 is a flowchart illustrating a method of measuring an SOC of a battery, according to one or more embodiments of the present disclosure.

FIG. 10 is a flow chart illustrating more details of a process for calculating the plurality of temperatures in the method of FIG. 9, according to one or more embodiments of the present disclosure.

## DETAILED DESCRIPTION

Hereinafter, embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, redundant description thereof may not be repeated.

When a certain embodiment may be implemented differently, a specific process order may be different from the described order. For example, two consecutively described processes may be performed at the same or substantially at the same time, or may be performed in an order opposite to the described order.

In the drawings, the relative sizes, thicknesses, and ratios of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

Any numerical range disclosed and/or recited herein is intended to include all subranges of the same numerical precision subsumed within the recited range. For example, a range of "1.0 to 10.0" is intended to include all subranges between (and including) the recited minimum value of 1.0 and the recited maximum value of 10.0, that is, having a minimum value equal to or greater than 1.0 and a maximum value equal to or less than 10.0, such as, for example, 2.4 to 7.6. Any maximum numerical limitation recited herein is intended to include all lower numerical limitations subsumed therein, and any minimum numerical limitation recited in this specification is intended to include all higher numerical limitations subsumed therein.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure.

It will be understood that when an element or layer is referred to as being "on," "connected to," or "coupled to" another element or layer, it can be directly on, connected to, or coupled to the other element or layer, or one or more intervening elements or layers may be present. Similarly, when a layer, an area, or an element is referred to as being "electrically connected" to another layer, area, or element, it may be directly electrically connected to the other layer, area, or element, and/or may be indirectly electrically connected with one or more intervening layers, areas, or elements therebetween. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," "including," "has," "have," and "having," when used in this specification, specify the presence of the stated features, integers, steps, operations, elements and/or components, but do not preclude the presence or addition of one or more other features, integers, steps, operations, elements, components, and/or groups thereof. As used herein, the term "and/or" includes any and all combinations of one or more of the associated listed items. For example, the expression "A and/or B" denotes A, B, or A and B. Expressions such as "at least one of," when preceding a list of elements, modify the entire list of elements and do not modify the individual elements of the list. For example, the expression "at least one of a, b, or c," "at least one of a, b, and c," and "at least one selected from the group consisting of a, b, and c" indicates only a, only b, only c, both a and b, both a and c, both b and c, all of a, b, and c, or variations thereof.

References to two compared elements, features, and the like as being "the same" as each other may mean that they are "substantially the same" as each other. Thus, the phrase "substantially the same" may include a case having a deviation that is considered low in the art, for example, such as a deviation of 5% or less. In addition, when a certain parameter is referred to as being uniform in a given region, it may mean that it is uniform in terms of an average.

Further, the term "module" or "unit" used herein refers to a software or hardware component, and "module" or "unit" performs certain roles. However, the meaning of the "module" or "unit" is not limited to software or hardware. The "module" or "unit" may be configured to be in an addressable storage medium or configured to play one or more processors. Accordingly, as an example, the "module" or "unit" may include components such as software components, object-oriented software components, class components, and task components, and at least one of processes, functions, attributes, procedures, subroutines, program code segments, drivers, firmware, micro-codes, circuits, data, database, data structures, tables, arrays, and variables. Furthermore, functions provided in the components and the "modules" or "units" may be combined into a smaller number of components and "modules" or "units", or further divided into additional components and "modules" or "units." In the present disclosure, "each of a plurality of A's" may refer to each of all components included in the A's or refer to each of some components included in the A's.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

As used herein, the term "state of charge (SOC)" refers to a remaining capacity dischargeable from a battery. The terms "remaining capacity" and "SOC" may be used interchangeably herein.

First, experimental data for a case where the temperature of a battery reaches a threshold temperature, and the discharge is terminated despite a remaining capacity (SOC) of the battery will be described. A battery management system may be designed to force the battery to terminate the discharge in order to maintain the stability of the battery in a situation where the temperature of the battery is increasing rapidly. In such a situation, the discharge of the battery may be terminated if the temperature of the battery reaches the threshold temperature, even though the SOC is still available.

Table 1 illustrates experimental data of tests performed on batteries mounted on cordless vacuums.

Table 1:

| | Cordless vacuum_1 (730w) | Cordless vacuum_2 (730w) | Cordless vacuum_3 (750w) | Cordless vacuum_4 (830w) |
|---|---|---|---|---|
| Threshold Temperature | T_th | T_th | T_th | T_th |
| SOC (Discharge Terminated) | 12.4% | 14.1% | 14.6% | 19.5% |
| Voltage (Discharge Terminated) | 3067mV | 3088mV | 3051 mV | 3093mV |
| Accumulated Current Value (Discharge Terminated) | 3212mAh | 3157mAh | 3097mAh | 2770mAh |

Referring to Table 1 above, data (e.g., SOCs, voltages, and accumulated current values) of batteries measured from each of a plurality of cordless vacuums that are operated such that the temperature of the battery exceeded a threshold temperature T_th (where T_th is a real number), and then the discharge was terminated due to the temperature increase, is shown.

In a case where the battery exceeds the threshold temperature T_th, the discharge may be forcibly terminated. However, a display (e.g., a display panel or a display device) of the cordless vacuum may output the SOC of the battery as still being available. For example, as shown in Table 1, the display of the Cordless vacuum_1 may output the SOC of the battery as being 12.4%, and the display of the Cordless vacuum_2 may output the SOC of the battery as being 14.1%, even though the discharge was forcibly terminated due to the temperature increase. The SOC of the battery being displayed as still being available after the termination of the discharge in response to the discharge termination condition established due to temperature increase as described above may act as a factor to reduce the reliability of a product.

According to one or more embodiments of the present disclosure, changes in the temperature of the battery may be predicted. In a case where the predicted change in the temperature is determined to reach a threshold temperature, an SOC change trend may be determined, so that the SOC change rate associated with the discharge is rapid or increased. Further, an SOC may be calculated on the basis of the determined SOC change trend, and may be output.

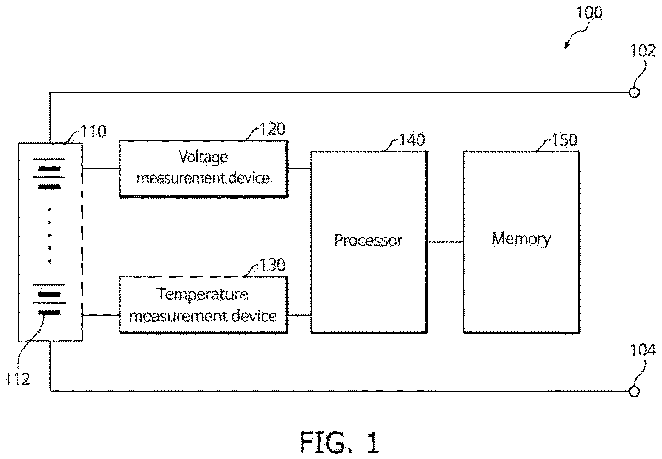

FIG. 1 illustrates a block diagram showing a schematic configuration of a battery management system 100, according to one or more embodiments of the present disclosure. Referring to FIG. 1, the battery management system 100 may include a battery 110, a voltage measurement device 120, a temperature measurement device 130, a processor 140, and a memory 150. The battery management system 100 may be used in a battery pack or a battery module including at least one battery cell 112.

The battery 110 may include a plurality of battery cells 112 provided between a first terminal 102 and a second terminal 104, and electrically connected to each other as a power storage. Respective battery cells of the battery cells 112 may be connected in series, connected in parallel, or connected in a combination of series and parallel. For example, respective battery cells of the battery cells 112 may discharge and recharge current of the same or substantially the same magnitude. In another example, respective battery cells of the battery cells 112 may have different internal statuses. For example, respective battery cells of the battery cells 112 may have different internal resistances and/or electromotive forces.

Each of the battery cells 112 may include a rechargeable secondary cell. For example, the battery cells 111 may include nickel-cadmium batteries, lead acid batteries, nickel metal hydride (NiMH) batteries, lithium ion batteries, lithium polymer batteries, and/or the like. The number of the battery cells 112 may be determined on the basis of a capacity, an output voltage, and/or an output current desired for the battery 110.

Although a single battery 110 is illustrated in FIG. 1, a plurality of batteries 110 may be connected to each other in parallel and/or series, and may be connected to a load and/or a charging device via the first terminal 102 and the second terminal 104. The battery 110 may be connected to a load and/or a charging device and in use. In addition, a method of calculating the SOC of a battery according to one or more embodiments of the present disclosure may also be used to calculate the SOC of the batteries 110 that are connected to each other in parallel and/or series.

The voltage measurement device 120 may measure a voltage between two electrodes of the battery 110 at suitable intervals (e.g., at predetermined intervals) to periodically generate a voltage value of the battery 110. In another example, the voltage measurement device 120 may measure a voltage of each of the battery cells 112 at suitable intervals (e.g., at predetermined intervals) to periodically generate a voltage value of each of the battery cells 112. In a case where respective battery cells of the battery cells 112 are connected in parallel, the voltage measurement device 120 may measure a voltage of one battery cell 112, and may determine that all of the other battery cells 112 that are connected in parallel have the same voltage value as that of the one battery cell 112.

The temperature measurement device 130 may measure a temperature of the battery 110 at suitable intervals (e.g., at predetermined intervals) to periodically generate a temperature value of the battery 110. The temperature measurement device 130 may measure a temperature of at least one battery cell of the battery cells 112 at the intervals (e.g., at the predetermined intervals) to periodically generate the temperature value of the battery 110.

The voltage value/temperature value that is periodically measured by the voltage measurement device 120 and/or the temperature measurement device 130 may be transmitted to the processor 140. The processor 140 may include a general purpose processor, a central processing unit (CPU), a microprocessor, a digital signal processor (DSP), a controller, a microcontroller, a state machine, or the like. In some embodiments, the processor 140 may refer to an application-specific integrated circuit (ASIC), a programmable logic device (PLD), a field programmable gate array (FPGA), or the like. The processor 140 may refer to, for example, a combination of processing devices, such as a combination of a DSP and a microprocessor, a combination of a plurality of microprocessors, a combination of one or more microprocessors combined with a DSP core, or any suitable combination thereof or any other such suitable configurations.

The memory 150 may include any suitable electronic component capable of storing electronic information. The memory 150 may refer to various suitable kinds of processor-readable media, such as a random access memory (RAM), a read-only memory (ROM), a nonvolatile random access memory (NVRAM), a programmable read-only memory (PROM), an erasable programmable read-only memory (EPROM), an electrically erasable PROM (EEPROM), a flash memory, a magnetic or optical data storage, registers, and/or the like. The memory 150 may be in electronic communication with the processor 140 in a case where the processor 140 may read information from the memory 150 and/or write information in the memory 150. The memory 150 may be integrated into the processor 140, and in electronic communication with the processor 140.

In an embodiment, the memory 150 may include any suitable non-transitory computer-readable recording medium. In an embodiment, the memory 150 may include a non-transitory permanent mass storage device. In another example, the non-transitory mass storage device may be a separate permanent storage device distinct from the memory 150, and may be included in the battery management system 100 or in a device accessible by the battery management system 100 in a wired or wireless manner. In another example, the memory 150 may be implemented as being included in the processor 140.

According to an embodiment, an operating system (OS) and at least one program code (e.g., program code for calculating battery SOC) may be stored on the memory 150. In addition, the memory 150 may store a first lookup table generated from a relationship between the SOC and a voltage. As used herein, the voltage may be an open circuit voltage (OCV). The first lookup table may store an SOC-related value (%) associated with each voltage. For example, a value of a% (where a is a positive real number) may be stored in the first lookup table with respect to a first voltage value and a second voltage value, and a value of b% (where b is a positive real number) may be stored in the first lookup table with respect to a third voltage value and a fourth voltage value. The first lookup table may be generated on the basis of result data obtained by simulating the relationship between the SOC and the voltage.

In addition, the memory 150 may store data for temperature prediction. In other words, the memory 150 may store a second lookup table generated from the relationship between the energy change and the temperature change in the battery. For example, a first temperature value that increases with respect to a first energy change, a second temperature value that increases with respect to a second energy change, and the like may be stored in the second lookup table. The second lookup table may be generated on the basis of result data obtained by simulating the relationship between the energy change and the temperature change.

In addition, the memory 150 may store a third lookup table generated from the relationship between the internal resistance of the battery and the voltage. For example, a first resistance value may be stored in the third lookup table with respect to a fifth voltage value, and a second resistance value may be stored in the third lookup table with respect to a sixth voltage value. The third lookup table may be generated on the basis of result data obtained by simulating the relationship between the voltage and the resistance. In some embodiments, the third lookup table and the first lookup table may be combined together into a single lookup table.

The processor 140 may be configured to process instructions of a computer program by performing basic arithmetic, logics, and input/output operations. According to an embodiment, the processor 140 may measure the SOC of the battery 110 at the present interval (hereinafter, also referred to as the "present-interval SOC of the battery 110") on the basis of the voltage obtained from the voltage measurement device 120 and first lookup table. In addition, the processor 140 may obtain a temperature of the battery 110 using the temperature measurement device 130. According to an embodiment, the processor 140 may calculate a plurality of temperatures associated with a plurality of battery SOCs gradually downgraded from the measured battery SOC by suitable levels (e.g., by predetermined levels), on the basis of the obtained temperature and the second lookup table. In addition, the processor 140 may determine a specific SOC associated with a discharge end point of the battery, on the basis of the calculated temperatures, and may determine the SOC change trend on the basis of the determined specific SOC. Herein, the trend of changes may be the trend of changes of decreasing SOCs in a case where the battery 110 is being discharged.

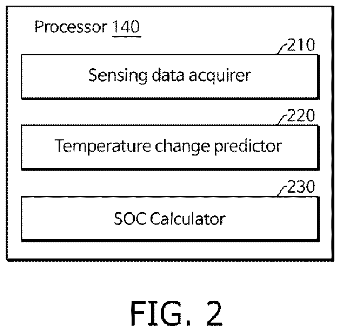

FIG. 2 illustrates a block diagram showing an internal configuration of the processor 140, according to one or more embodiments of the present disclosure. As illustrated in FIG. 2, the processor 140 may include a sensing data acquirer 210, a temperature change predictor 220, and an SOC calculator 230. Each of the sensing data acquirer 210, the temperature change predictor 220, and the SOC calculator 230 may be part of the processor 140, for example, implemented as instructions stored in the memory 105 and executed by the processor 140, or implemented as different processing elements of the processor 140.

The sensing data acquirer 210 may acquire sensing data including a voltage and/or a temperature. For example, the sensing data acquirer 210 may acquire the sensing data including the voltage measured by the voltage measurement device 120 and/or the temperature measured by the temperature measurement device 130. The sensing data acquirer 210 may acquire the sensing data at suitable intervals (e.g., at predetermined intervals).

The temperature change predictor 220 may predict a future temperature change trend of the battery on the basis of a first SOC of the battery at the present time point, a first temperature of the battery obtained at the present interval, and the second lookup table.

In more detail, the temperature change predictor 220 may identify an internal resistance corresponding to the voltage obtained at the present interval from the third lookup table, and may calculate a temperature coefficient based on the identified internal resistance, the voltage, and a time dt. Herein, the temperature coefficient indicates a temperature change with respect to the discharged energy. As the discharged energy is smaller, the temperature coefficient having a smaller magnitude may be calculated.

According to an embodiment, the temperature coefficient may be calculated using Equation 1 below.

Equation 1:

$$k = \frac{dT}{I^2 \times \left(\frac{ESR}{p}\right) \times dt}$$

In Equation 1, k may be a temperature coefficient, dT may be a temperature change, I may be a current, p may be the number of battery cells, dt may be a time change, and ESR may be an equivalent resistance. The equivalent resistance may be calculated on the basis of an internal resistance. Herein, the time dt may be determined on the basis of the measurement interval of the voltage. In addition, the current may be calculated on the basis of the equivalent resistance and the voltage, and may be substituted into Equation 1.

In addition, an amount of energy change currently being discharged may be calculated, and an amount of temperature change dT associated with the calculated energy change may be obtained from the second lookup table, and may be applied to Equation 1. For example, the amount of energy change may be calculated on the basis of the current of the battery.

The temperature change predictor 220 may determine a second SOC downgraded from the present-interval SOC of the battery by a grade (e.g., a predetermined grade), obtain a second voltage associated with the second SOC from the first lookup table, and obtain a second internal resistance associated with the second voltage from the third lookup table. In addition, the temperature change predictor 220 may calculate a second temperature associated with the downgraded second SOC on the basis of the first temperature, the temperature coefficient k, the second voltage, and the second internal resistance measured at the present interval. Herein, the second temperature may be a battery temperature at a future time point.

According to an embodiment, the temperature change predictor 220 may calculate an amount of temperature change for the downgraded second SOC, and may add the calculated amount of temperature change for the second SOC to the first temperature to calculate a second temperature at the second SOC using Equation 2 below.

Equation 2:

$$\Delta T_i = \frac{3600 \times Q_{max} \times \Delta S}{100} \times (k \times I \times R)$$

In Equation 2, $\Delta T_i$ may be an amount of temperature change associated with an SOC downgraded by an 'i' grade, $Q_{max}$ may be the maximum capacity of the battery, $\Delta S$ may be an amount of SOC change, k may be a temperature coefficient, I may be a current, and R may be a resistance. Herein, $Q_{max}$ may be predetermined and stored. The current may be calculated on the basis of the second voltage and the second internal resistance, and may be applied to Equation 2.

In addition, the temperature change predictor 220 may determine a third SOC downgraded from the downgraded second SOC by a grade (e.g., a predetermined grade), obtain a third voltage associated with the third SOC from the first lookup table, and obtain a third internal resistance associated with the third voltage from the third lookup table. In addition, the temperature change predictor 220 may predict a third temperature associated with the downgraded third SOC on the basis of the second temperature associated with the second SOC, the temperature coefficient k, the third voltage, and the third internal resistance. For example, the temperature change predictor 220 may calculate an amount of temperature change for the downgraded third SOC, and may add the calculated amount of temperature change for the third SOC to the second temperature to calculate a third temperature associated with the third SOC using Equation 2 above.

The temperature change predictor 220 may calculate a temperature of each of a fourth SOC, ..., to an nth SOC (where n is a natural number greater than or equal to 5) downgraded from the third SOC by the method described above.

The temperature change predictor 220 may predict a temperature change trend of the battery on the basis of the calculated temperature of each of the SOCs.

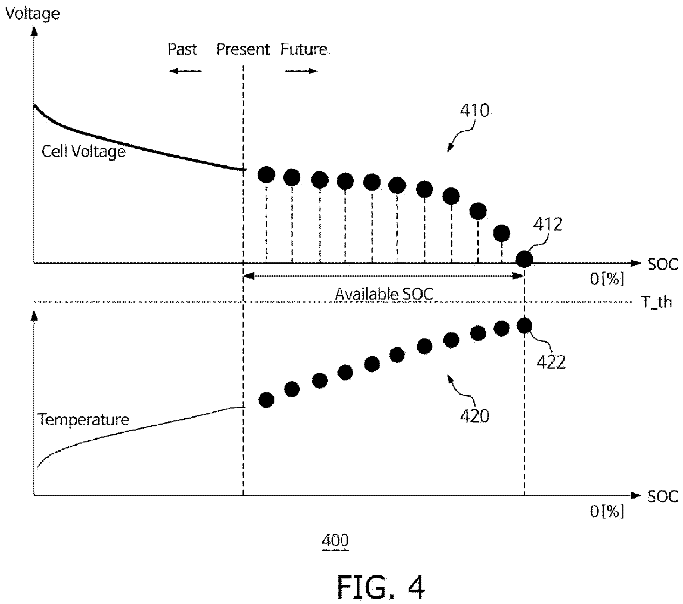

The SOC calculator 230 may calculate the present-interval SOC of the battery on the basis of the voltage included in the sensing data and the first lookup table. In addition, the SOC calculator 230 may calculate the SOC of the battery to be output on the basis of the temperature change trend predicted by the temperature change predictor 220. According to an embodiment, the SOC calculator 230 may determine that in a case where the temperature of the battery is determined to exceed the threshold temperature before the voltage of the battery is equal to or lower than a final discharge voltage, the SOC associated with the temperature exceeding the threshold temperature is a specific SOC associated with the final discharge voltage, on the basis of the calculated temperatures. In this case, the SOC calculator 230 may determine the SOC change rate to reduce the range of available SOCs, or may determine the SOC change rate such that the SOC change rate associated with the discharge is more rapid. Some examples of determining the SOC change rate will be described in more detail below with reference to FIGS. 4 through 8.

The SOC calculator 230 may periodically calculate the SOC, and output the calculated SOC. For example, the SOC calculator 230 may output the calculated SOC by means of a display (e.g., a display panel or a display device) associated with processor 140.

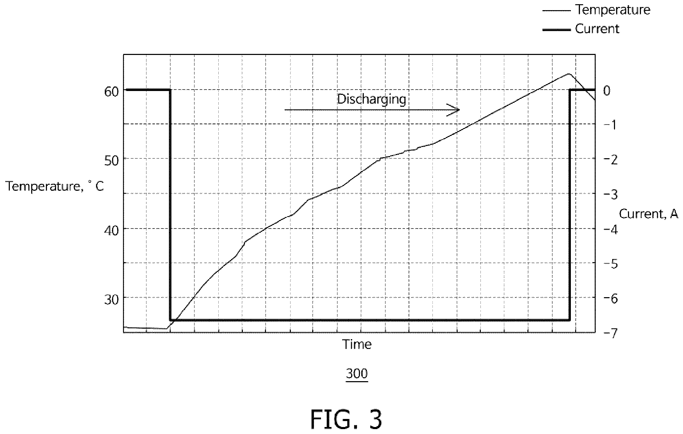

FIG. 3 is a graph illustrating a temperature change trend according to an amount of energy change, according to one or more embodiments of the present disclosure. In FIG. 3, the discharge energy is illustrated as Current values. As illustrated in FIG. 3, in a case where the discharge energy is continuously generated, the temperature of the battery may continuously increase. In addition, in a case where no discharge energy is generated, the temperature of the battery may decrease.

An amount of the discharged energy and an amount of the temperature change may be simulated depending on a type of the battery, and the second lookup table may be generated on the basis of the simulation results thereof.

FIG. 4 is a graph illustrating an example of a voltage change trend 410 and a temperature change trend 420 of a battery, according to one or more embodiments of the present disclosure. Referring to FIG. 4, a first SOC of the battery may be determined on the basis of a first voltage obtained at the present interval. For example, the SOC associated with the obtained voltage may be obtained from the first lookup table, and the obtained SOC may be determined to be the first SOC of the battery. Herein, the first SOC may be the battery SOC at the present time point.

In addition, a plurality of SOCs gradually downgraded from the first SOC by a grade (e.g., a predetermined grade) may be determined, and a voltage for each of the determined SOCs may be determined. The voltages associated with the downgraded SOCs may be determined using the first lookup table. In FIG. 4, the voltages associated with the downgraded SOCs are indicated as dots in the upper graph. The voltage change trend 410 of the battery may be determined on the basis of the respective voltages of the SOCs.

An SOC 412 associated with a final discharge voltage may be determined from the downgraded SOCs on the basis of the voltage change trend 410. For example, an SOC associated with a voltage equal to or lower than a threshold voltage (e.g., a predetermined threshold voltage) may be identified as being the SOC 412 associated with the final discharge voltage. As illustrated in FIG. 4, a range from the present SOC to the SOC 412 associated with the final discharge voltage may be identified as available SOCs.

In addition, a temperature of each of the downgraded SOCs may be calculated. As described above, the temperature of each of the downgraded SOCs may be calculated using at least one of Equation 1, Equation 2, or the second lookup table. In FIG. 4, the temperatures associated with the downgraded SOCs are indicated as dots in the lower graph. The temperature change trend 420 of the battery may be determined on the basis of the respective temperatures of the SOCs.

A specific SOC associated with an actual termination of the discharge of the battery may be determined on the basis of the voltage change trend 410 and/or the temperature change trend 420. According to an embodiment, whether or not the temperature of the battery exceeds the threshold temperature $T\_th$ (where $T\_th$ is a real number) may be determined before the voltage of the battery is equal to or lower than the final discharge voltage, on the basis of temperature change trend 420. In other words, whether or not an SOC associated with the temperature exceeding the threshold temperature $T\_th$ is present may be determined on the basis of the temperature change trend 420. In a case where the battery is determined to not exceed the threshold temperature $T\_th$ before the termination of the discharge, the SOC 412 associated with the final discharge voltage determined from voltage change trend 410 may be determined to be the specific SOC associated with the actual discharge termination.

In FIG. 4, a highest temperature 422 from among the temperatures included in the temperature change trend 420 is illustrated as being equal to or below the threshold temperature $T\_th$, and thus, the SOC 412 associated with the final discharge voltage and the SOC associated with the actual discharge termination may be determined. In addition, the available SOCs may be determined to range from the present SOC to the final discharge SOC 412. In this case, an SOC associated with a voltage measured during a subsequent interval may be identified by means of the first lookup table, and the identified SOC may be output.

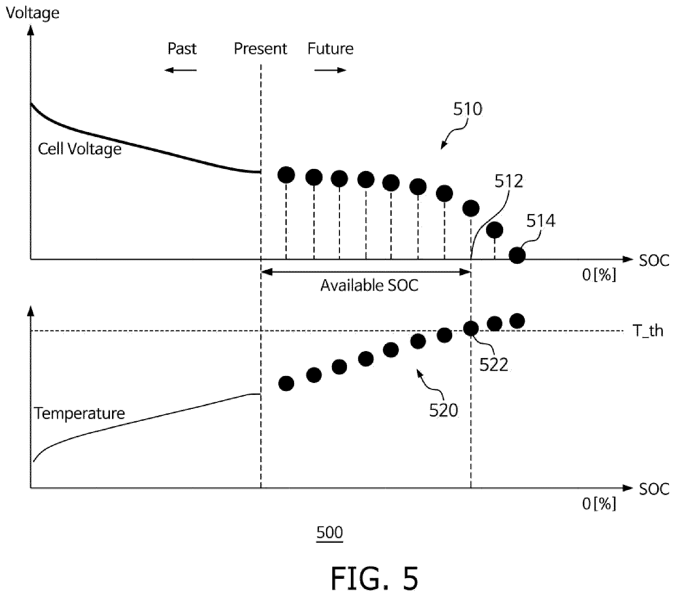

FIG. 5 is a graph illustrating another example of a voltage change trend 510 and a temperature change trend 520 of a battery, according to one or more embodiments of the present disclosure. When comparing the graph of FIG. 5 with the graph of FIG. 4, the voltage change trend 510 and the temperature change trend 520 illustrated in FIG. 5 are recalculated at a time point after a period (e.g., a predetermined period) of time from the present time point in FIG. 4. In other words, the present time point in FIG. 5 is illustrated to the right of the present time point in FIG. 4. When comparing the temperature change trend 520 illustrated in FIG. 5 with the temperature change trend 420 illustrated in FIG. 4, it may be determined that the temperature has increased.

A temperature exceeding a threshold temperature $T\_th$ (where $T\_th$ is a real number) may be found on the temperature change trend 520. In other words, in FIG. 5, the temperature associated with an SOC downgraded from the present SOC by a grade 8 or higher is illustrated as exceeding the threshold temperature $T\_th$. An SOC, from among the SOCs, associated with a temperature 522 first exceeding the threshold temperature $T\_th$ may be identified on the basis of the temperature change trend 520. In FIG. 5, the SOC downgraded from the present-interval SOC by the grade 8 is illustrated as being the SOC associated with the temperature 522 first exceeding the threshold temperature $T\_th$.

In a case where the temperature of the battery exceeds the threshold temperature $T\_th$ before the voltage of the battery is equal to or lower than the final discharge voltage, the SOC associated with the temperature 522 first exceeding the threshold temperature $T\_th$ may be determined to be an SOC 512 associated with the actual discharge end point. FIG. 5 shows that the SOC associated with the actual discharge end point has changed from an SOC 514 associated with a discharge voltage equal to or lower than the threshold voltage to the SOC 512 associated with the temperature 522 exceeding the threshold temperature $T\_th$. With changes in the SOC associated with the discharge termination, the range of the available SOCs may also be reduced.

In a case where the range of the available SOCs is reduced, the SOC change trend may be determined so that the SOC change rate according to the discharge of the battery is more rapid. For example, the SOC change rate may be adjusted to have a sharper slope. The magnitude by which the voltage change trend changes may be determined on the basis of the difference between the SOC associated with the discharge end point and the present SOC. In other words, the magnitude by which the voltage change trend changes may be determined on the basis of the range of available SOCs.

After the SOC change trend 520 is adjusted in the above-described manner, the SOC associated with a voltage acquired at a subsequent interval may be identified by means of the first lookup table. The SOC may be calculated and output on the basis of the voltage and the adjusted SOC change trend.

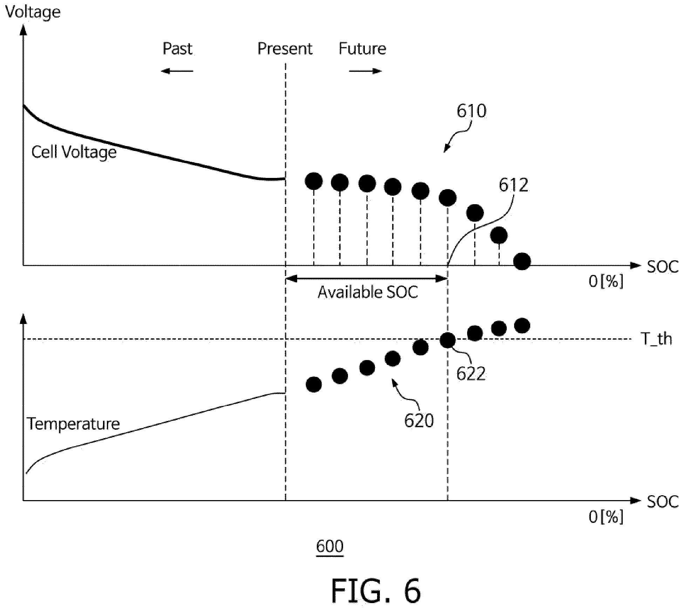

FIG. 6 is a graph illustrating another example of a voltage change trend 610 and a temperature change trend 620 of a battery, according to one or more embodiments of the present disclosure. When comparing FIG. 6 with FIG. 5, the voltage change trend 610 and the temperature change trend 620 illustrated in FIG. 6 are recalculated after a period (e.g., a predetermined period) of time from the present time point in FIG. 5. In other words, the present time point in FIG. 6 is illustrated to the right of the present time point in FIG. 5. When comparing the temperature change trend 620 illustrated in FIG. 6 with the temperature change trend 520 illustrated in FIG. 5, it may be determined that the temperature has increased.

In FIG. 6, a temperature associated with an SOC downgraded from the present-interval SOC by a grade 6 or higher is illustrated as exceeding the threshold temperature T_th (where T_th is a real number). An SOC, from among the SOCs, associated with a temperature 622 first exceeding the threshold temperature T_th may be identified on the basis of the temperature change trend 620. In addition, an SOC 612 associated with the temperature 622 first exceeding the threshold temperature T_th may be determined to be the SOC associated with the actual discharge end point. In a case where the SOC associated with the actual termination of the discharge is moved forward, the range of available SOCs may also be reduced.

In a case where the range of available SOCs is further reduced, the SOC change trend may be determined so that the SOC change rate is more rapid. Here, the SOC may be calculated and output so that the discharge ratio of the battery is higher.

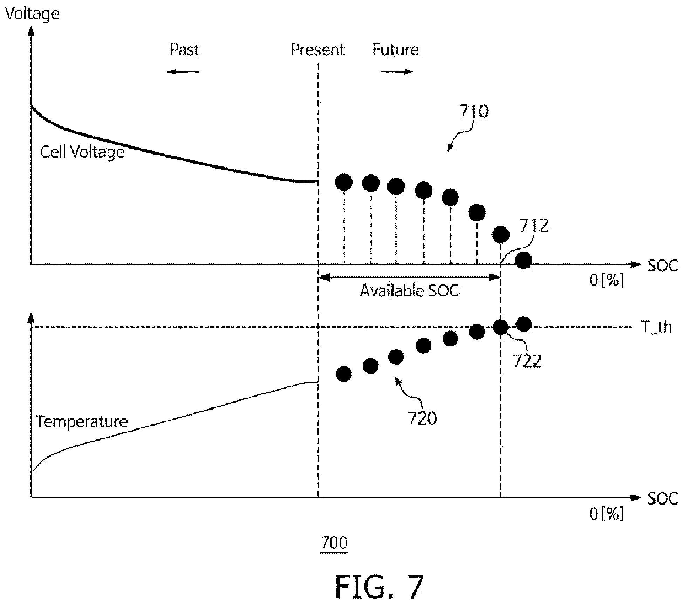

FIG. 7 is a graph illustrating another example of a voltage change trend 710 and a temperature change trend 720 of a battery, according to one or more embodiments of the present disclosure. When comparing FIG. 7 with FIG. 6, the voltage change trend 710 and the temperature change trend 720 illustrated in FIG. 7 are recalculated after a period (e.g., a predetermined period) of time from the present time point in FIG. 6. In other words, the present time point in FIG. 7 is shown to the right of the present time point in FIG. 6. When comparing the temperature change trend 720 illustrated in FIG. 7 with the temperature change trend 620 illustrated in FIG. 6, it may be determined that the slope of the temperature increase is becoming smoother.

In FIG. 7, a temperature associated with the SOC downgraded from the present SOC by a grade 7 or higher is illustrated as exceeding the threshold temperature T_th (where T_th is a real number). An SOC, from among the SOCs, associated with a temperature 722 first exceeding the threshold temperature T_th may be identified on the basis of the temperature change trend 720.

On the basis of the temperature change trend 720, an SOC 712 associated with the temperature 722 first exceeding the threshold temperature T_th may be determined to be the SOC associated with the actual discharge end point. In a case where the SOC associated with the discharge termination is more spaced apart from the present SOC, the range of available SOCs may be increased. In a case where the range of available SOCs is increased, the SOC change trend may be determined so that the SOC change rate is gradual.

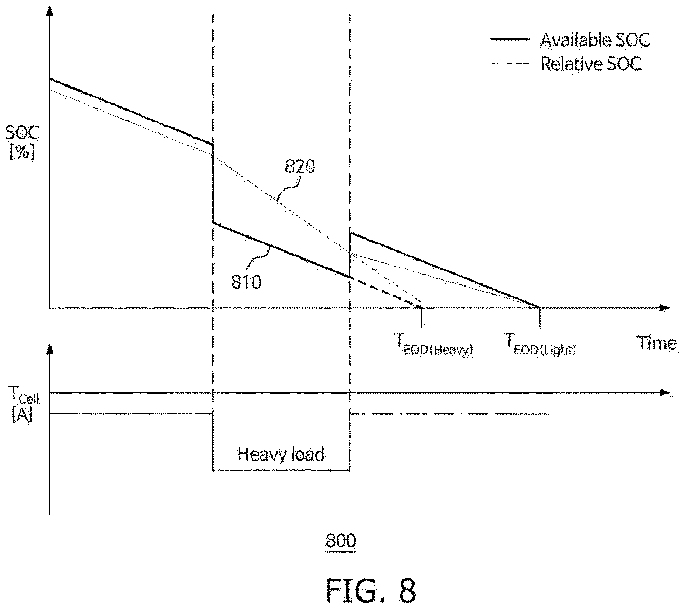

FIG. 8 is a graph illustrating an example of a fluctuating SOC change trend, according to one or more embodiments of the present disclosure. In FIG. 8, the available SOCs (Available SOC) are SOCs calculated in response to the discharge environment, and may be determined to be in the range between the SOC calculated at the present interval and the SOC associated with the actual discharge termination. In addition, relative SOCs (Relative SOC) may be SOCs output on the display, and may be calculated on the basis of the available SOCs.

As illustrated in FIG. 8, there may be a heavy load section where the discharge of the battery is weighted. The weighted discharge of the battery may cause the temperature of the battery to increase, and the temperature of the battery may be predicted to exceed the threshold temperature at a future point in time. In this case, the SOC change trend may be adjusted so that the available SOCs change trend changes more abruptly. As illustrated in FIG. 8, an SOC change trend 810 may be adjusted so that the available SOCs in the discharge-weighted section drop, and a relative SOC change trend 820 may be adjusted on the basis of the available SOC change trend.

In addition, the discharge end point of the battery may be determined on the basis of the adjusted SOC change trend 810 and 820. In FIG. 8, the discharge end point of the battery is illustrated as being a time point associated with $T_{EOD(Heavy)}$. For example, with increases in the temperature due to the weighted load of the battery, the actual discharge end point may be changed from a point associated with $T_{EOD(Light)}$ to a point associated with $T_{EOD(Heavy)}$. In this case, the available SOC change trend 810 and/or the relative SOC change trend 820 may be adjusted so that the $T_{EOD(Heavy)}$ is the end point. In FIG. 8, the change trends are illustrated as being adjusted with dotted lines.

In a case where the available SOC is adjusted on the basis of the temperature change trend as described above, the remaining capacity of the battery output at the discharge end point may be displayed as little or none (e.g., 0%), thereby preventing or substantially preventing an error in the remaining capacity of the battery that is output at the discharge end point.

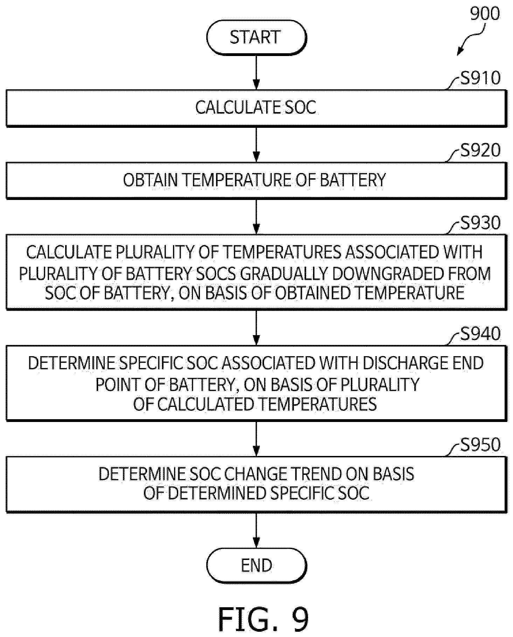

FIG. 9 is a flowchart illustrating a method 900 of measuring an SOC of a battery, according to one or more embodiments of the present disclosure. At least some of the processes of the method 900 illustrated in FIG. 9 may be performed by the processor 140 included in the battery management system 100 illustrated in FIG. 1. For convenience, the method 900 of FIG. 9 will be described in more detail hereinafter as being performed by the processor 140 included in the battery management system 100 in FIG. 1.

The processor 140 may calculate the SOC of a battery (S910). According to an embodiment, the processor 140 may calculate the SOC at the present interval on the basis of the voltage of the battery obtained at the present interval and the first lookup table.

Thereafter, the processor 140 may obtain a temperature of the battery (S920). For example, the processor may obtain the temperature of the battery from a temperature measurement device (e.g., the temperature measurement device 130).

Subsequently, the processor 140 may calculate a plurality of temperatures associated with a plurality of battery SOCs gradually downgraded from a calculated battery SOC by grades (e.g., predetermined grades), on the basis of the obtained temperatures (S930). For example, the processor 140 may calculate the temperatures associated with the gradually downgraded SOCs on the basis of a table in which temperature changes according to an amount of energy change are recorded.

Thereafter, the processor 140 may determine a specific SOC associated with a discharge end point of the battery on the basis of the calculated temperatures (S940). According to an embodiment, the processor 140 may determine an SOC exceeding the threshold temperature to be the specific SOC associated with the discharge end point, on the basis of the calculated temperatures. For example, the processor 140 may determine whether or not the temperature of the battery exceeds the threshold temperature before the voltage of the battery is equal to or lower than the final discharge voltage, on the basis of the calculated temperatures. In a case where the temperature of the battery is determined to exceed the threshold temperature before the voltage of the battery is equal to or lower than the final discharge voltage, the processor 140 may determine the SOC associated with the temperature exceeding the threshold temperature to be the specific SOC associated with the discharge end point. In this case, the processor 140 may determine the SOC change trend so that the range of available SOCs is reduced, or may determine the SOC change trend so that the change rate of the SOC associated with the discharge is more rapid.

In another example, the processor 140 may calculate a plurality of voltages associated with the battery SOCs gradually downgraded from the measured battery SOC by a grade (e.g., a predetermined grade), and on the basis of the calculated voltages, and it may determine an SOC associated with a final discharge voltage at which the voltage of the battery is equal to or lower than the final discharge voltage. In a case where the temperature of the battery is determined to not have exceeded the threshold temperature before the voltage of the battery is equal to or lower than the final discharge voltage, the processor may determine the SOC associated with the final discharge voltage to be the specific SOC associated with the discharge end point.

Subsequently, the processor may determine an SOC change trend on the basis of the determined specific SOC (S950).

After the SOC change trend is determined, the processor 140 may obtain the voltage of the battery, and on the basis of the obtained voltage of the battery and the SOC change trend, it may calculate an SOC to be output. In another example, after the SOC change trend is determined, the processor 140 may determine a range of available SOCs on the basis of the determined specific SOC, and may determine a discharge ratio for the battery on the basis of the range of available SOCs. Thereafter, the processor 140 may obtain a voltage of the battery, and may calculate an SOC to be output (e.g., on a display) on the basis of the obtained voltage of the battery and the discharge ratio of the battery.

The method 900 illustrated in FIG. 9 may be performed at a single analysis interval, and/or may be performed repeatedly at a plurality of analysis intervals (e.g., a plurality of predetermined analysis intervals).

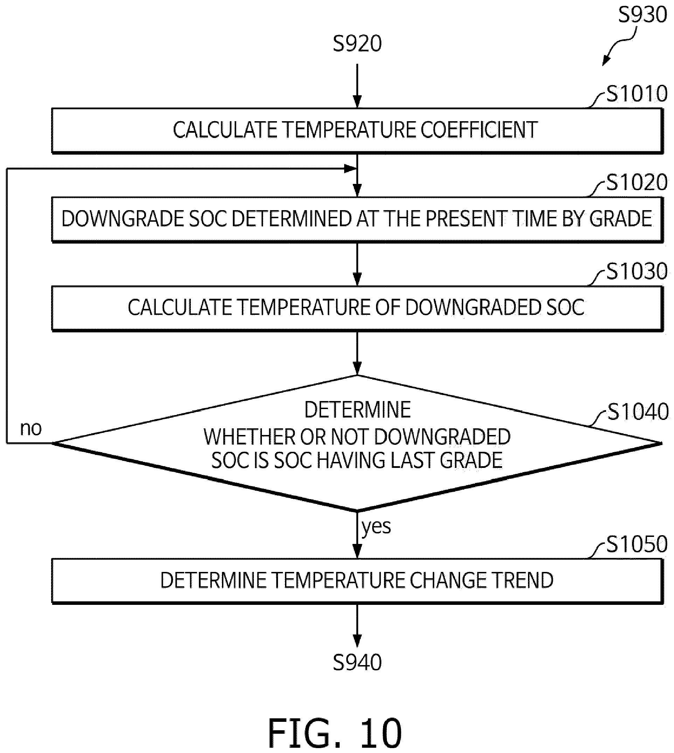

FIG. 10 is a flow chart illustrating more details of the process for calculating the plurality of temperatures (S930) in the method 900 of FIG. 9, according to one or more embodiments of the present disclosure. Referring to FIG. 10, the processor 140 may calculate a temperature coefficient (S1010). According to an embodiment, the processor 140 may calculate the temperature coefficient according to Equation 1 above.

Thereafter, the processor 140 may downgrade the SOC determined at the present time by a grade (e.g., a predetermined grade) (S1020), and may then calculate the temperature of the downgraded SOC (S1030). For example, the processor 140 may calculate a voltage, a current, and a resistance on the basis of the downgraded SOC, and may calculate a temperature for the downgraded SOC on the basis of the acquired temperature for the battery, the calculated voltage, the calculated current, and the calculated resistance. In such a case, the processor 140 may calculate the temperature for the downgraded SOC according to Equation 2 above.

Subsequently, the processor 140 may determine whether or not the downgraded SOC is an SOC having the last grade (e.g., the predetermined last grade) (S1040). In a case where the downgraded SOC is not the SOC having the last grade, the processor 140 may additionally downgrade the downgraded SOC by a suitable grade (e.g., a predetermined grade), and may then repeat the process (S1020) of calculating the temperature of the further downgraded SOC.

In another example, in a case where the downgraded SOC is determined to be the SOC of the last grade (e.g., the predetermined last grade), the processor 140 may predict a temperature change trend for the battery on the basis of the respective temperatures of the calculated SOCs.

Embodiments are set out in the following clauses:

Clause 1. A method of calculating a state of charge of a battery, which is executed by at least one processor, the method comprising: calculating a state of charge (SOC) of a battery; obtaining a temperature of the battery;

calculating, on basis of the obtained temperature, a plurality of temperatures associated with a plurality of SOCs of the battery gradually downgraded from the calculated SOC of the battery by a predetermined grade; determining, on basis of the calculated plurality of temperatures, a specific SOC associated with a discharge end point of the battery; and determining, on basis of the determined specific SOC, a change trend of the SOC.

Clause 2. The method according to clause 1, further comprising: after the determining of the change trend of the SOC, obtaining a voltage of the battery; and on basis of the obtained voltage of the battery and the change trend of the SOC, calculating an SOC to be output.

Clause 3. The method according to clause 1, further comprising: after the determining of the change trend of the SOC, determining, on basis of the determined specific SOC, a range of available SOCs; determining, on basis of the range of available SOCs, a discharge ratio of the battery; obtaining a voltage of the battery; and calculating, on basis of the obtained voltage of the battery and the discharge ratio of the battery, an SOC to be output.

Clause 4. The method according to clause 1, wherein the calculating of the plurality of temperatures comprises calculating the plurality of temperatures associated with the plurality of SOCs gradually downgraded on basis of a table in which temperature changes are recorded according to an amount of energy change.

Clause 5. The method according to clause 1, wherein the determining of the specific SOC associated with the discharge end point comprises determining, on basis of the calculated plurality of temperatures, an SOC exceeding a threshold temperature as the specific SOC associated with the discharge end point.

Clause 6. The method according to clause 1, wherein the calculating of the plurality of temperatures comprises: calculating a first temperature associated with a first SOC downgraded from the calculated SOC of the battery by a predetermined grade; and calculating a second temperature associated with a second SOC downgraded from the first SOC by the predetermined grade.

Clause 7. The method according to clause 6, wherein the calculating of the first temperature comprises: calculating, on basis of the first SOC, a voltage, a current, and a resistance; and on basis of the obtained temperature of the battery, the calculated voltage, the calculated current, and the calculated resistance, calculating the first temperature.

Clause 8. The method according to clause 7, wherein the calculating of the first temperature comprises calculating an amount of temperature change in the first SOC using a following Equation and calculating, on basis of the calculated

$$〚\Delta T〛\_i = (3600 \times Q\_max \times \Delta S)/100 \times (k \times I \times R)$$

amount of temperature change, the first temperature:                                                                                          , where $\Delta T_i$ is an amount of temperature change associated with an SOC downgraded by an i grade, Qmax is a maximum capacity of the battery, $\Delta s$ is an amount of SOC change, k is a temperature coefficient, I is a current, and R is a resistance.

Clause 9. The method according to clause 8, wherein the calculating of the first temperature comprises calculating a temperature coefficient using a following Equation: $k = dT/(I^2 \times (ESR/p) \times dt)$, where k is a temperature coefficient, dT is a temperature change, I is a current, p is a number of battery cells, dt is a time change, and ESR is an equivalent resistance.

Clause 10. The method according to clause 1, wherein the determining of the specific SOC associated with the discharge end point comprises: determining, on basis of the calculated plurality of temperatures, whether the temperature of the battery exceeds a threshold temperature before a voltage of the battery is equal to or lower than a final discharge voltage; and in a case where the temperature of the battery is determined to exceed the threshold temperature before the voltage of the battery is equal to or lower than the final discharge voltage, determining an SOC associated with exceeding the threshold temperature to be the specific SOC associated with the discharge end point.

Clause 11. The method according to clause 10, wherein the determining of the change trend of the SOC comprises, in a case where the SOC associated with exceeding the threshold temperature is determined to be the specific SOC associated with the discharge end point, determining the change trend of the SOC such that a range of available SOCs is reduced.

Clause 12. The method according to clause 10, wherein the determining of the change trend of the SOC comprises, in a case where the SOC associated with exceeding the threshold temperature is determined to be the specific SOC associated with the discharge end point, determining the change trend of the SOC such that an SOC change rate associated with the discharge is more rapid.

Clause 13. The method according to clause 10, wherein the determining of the SOC associated with exceeding the threshold temperature comprises: calculating a plurality of voltages associated with the plurality of SOCs of the battery gradually downgraded from the calculated battery SOC by a predetermined grade; determining, on basis of the calculated voltages, an SOC associated with the final discharge voltage, at which the voltage of the battery is equal to or lower than the final discharge voltage; and in a case where the temperature of the battery is determined to not exceed the threshold temperature before the voltage of the battery is equal to or lower than the final discharge voltage, determining the SOC associated with the final discharge voltage to be the specific SOC associated with the discharge end point.

Clause 14. A non-transitory computer-readable recording medium comprising instructions executable on a computer to perform the method as claimed in claim 1.

Clause 15. A battery management system comprising: a memory; and at least one processor connected to the memory and configured to execute at least one computer-readable program included in the memory, wherein the at least one program comprises instructions for: calculating a state of charge (SOC) of a battery; obtaining a temperature of the battery; calculating, on basis of the obtained temperature, a plurality of temperatures associated with a plurality of SOCs of the battery gradually downgraded from the calculated SOC of the battery by a predetermined grade; determining, on basis of the calculated plurality of temperatures, a specific SOC associated with a discharge end point of the battery; and determining, on basis of the determined specific SOC, a change trend of the SOC.

Clause 16. The battery management system according to clause 15, wherein the at least one program further comprises instructions for obtaining a voltage of the battery and on basis of the obtained voltage of the battery and the change trend of the SOC, calculating an SOC to be output.

Clause 17. The battery management system according to clause 15, wherein the at least one program further comprises instructions for: determining, on basis of the determined specific SOC, a range of available SOCs; determining, on basis of the range of available SOCs, a discharge ratio of the battery; obtaining a voltage of the battery; and on basis of the obtained voltage of the battery and the discharge ratio of the battery, calculating an SOC to be output.

Clause 18. The battery management system according to clause 15, wherein the calculating of the plurality of temperatures comprises: calculating a first temperature associated with a first SOC downgraded from the calculated SOC of the battery by a predetermined grade; and calculating a second temperature associated with a second SOC downgraded from the first SOC by the predetermined grade.

Clause 19. The battery management system according to clause 15, wherein the determining of the specific SOC associated with the discharge end point comprises: determining, on basis of the calculated temperatures, whether the temperature of the battery exceeds a threshold temperature before a voltage of the battery is equal to or lower than a final discharge voltage; and in a case where the temperature of the battery is determined to exceed the threshold temperature before the voltage of the battery is equal to or lower than the final discharge voltage, determining an SOC associated with exceeding the threshold temperature to be the specific SOC associated with the discharge end point.

Clause 20. The battery management system according to clause 19, wherein the determining of the change trend of the SOC comprises, in a case where the SOC associated with exceeding the threshold temperature is determined to be the specific SOC associated with the discharge end point, determining the change trend of the SOC such that an SOC change rate associated with the discharge is more rapid.

The above flowcharts and related description are provided as examples, and the methods may be implemented differently in some embodiments. For example, in some embodiments, the order of each process may be reversed, some processes may be performed repeatedly, some processes may be omitted, and some processes may be added.

The methods described above may be provided as a computer program stored on computer-readable recording media (e.g., memory, and the like) to be executed on a computer. The media may continuously store computer-executable programs or may transitorily store the same for execution or download. The media may also include various suitable kinds of recording devices or storage devices in a form in which one or a plurality of hardware components are combined. The media may be distributed over a network without being limited to media that is directly connected to a computer system. Examples of the media include magnetic media, such as hard disks, floppy disks, and magnetic tapes, optical media, such as CD-ROM and DVDs, magneto-optical media, such as floptical disks, and hardware devices configured to store program instructions, such as read-only memory (ROM), random access memory (RAM), flash memory, and the like. Examples of other media may include record media and storage media managed by an app store that distributes applications, a site that supplies and distributes other various kinds of software, a server, or the like.

The foregoing is illustrative of some embodiments of the present disclosure, and is not to be construed as limiting thereof. Although some embodiments have been described, those skilled in the art will readily appreciate that various modifications are possible in the embodiments without departing from the scope of the present disclosure. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific embodiments disclosed herein, and that various modifications to the disclosed embodiments, as well as other example embodiments, are intended to be included within the scope of the present disclosure as defined in the appended claims, and their equivalents.

**Claims**

1. A method of calculating a state of charge of a battery, comprising:

   calculating, by at least one processor, a state of charge (SOC) of a battery;
   obtaining, by the at least one processor, a temperature of the battery;
   calculating, by the at least one processor, based on the obtained temperature, a plurality of temperatures associated with a plurality of SOCs of the battery that are gradually downgraded from the calculated SOC of the battery by a grade;
   determining, by the at least one processor, based on the calculated plurality of temperatures, a specific SOC associated with a discharge end point of the battery; and
   determining, by the at least one processor, based on the determined specific SOC, a change trend of the SOC of the battery.

2. The method as claimed in claim 1, further comprising:

   obtaining, by the at least one processor, a voltage of the battery after the determining of the change trend of the SOC; and
   calculating, by the at least one processor, an SOC to be output based on the obtained voltage of the battery and the change trend of the SOC.

3. The method as claimed in claim 1 or claim 2, further comprising:

   determining, by the at least one processor, based on the determined specific SOC, a range of available SOCs after the determining of the change trend of the SOC;
   determining, by the at least one processor, based on the range of available SOCs, a discharge ratio of the battery;
   obtaining, by the at least one processor, a voltage of the battery; and
   calculating, by the at least one processor, based on the obtained voltage of the battery and the discharge ratio of the battery, an SOC to be output.

4. The method as claimed in any one of the preceding claims, wherein the calculating of the plurality of temperatures comprises calculating, by the at least one processor, the plurality of temperatures associated with the plurality of SOCs that are gradually downgraded based on a table comprising temperature changes according to an amount of energy change.

5. The method as claimed in any one of the preceding claims, wherein the determining of the specific SOC associated with the discharge end point comprises determining, by the at least one processor, based on the calculated plurality of temperatures, an SOC that exceeds a threshold temperature as the specific SOC associated with the discharge end point.

6. The method as claimed in any one of the preceding claims, wherein the calculating of the plurality of temperatures comprises:

   calculating, by the at least one processor, a first temperature associated with a first SOC that is downgraded from the calculated SOC of the battery by the grade; and
   calculating, by the at least one processor, a second temperature associated with a second SOC that is downgraded from the first SOC by the grade.

7. The method as claimed in claim 6, wherein the calculating of the first temperature comprises:

   calculating, by the at least one processor, based on the first SOC, a voltage, a current, and a resistance; and
   calculating, by the at least one processor, the first temperature based on the obtained temperature of the battery, the calculated voltage, the calculated current, and the calculated resistance.

8. The method as claimed in claim 7, wherein the calculating of the first temperature comprises:

   calculating, by the at least one processor, an amount of temperature change in the first SOC according to

$$\Delta T_i = \frac{3600 \times Q_{max} \times \Delta S}{100} \times (k \times I \times R)$$

; and

calculating, by the at least one processor, based on the calculated amount of temperature change, the first temperature,

wherein $\Delta T_i$ is the amount of temperature change associated with an SOC downgraded by an $i$ grade, $Q_{max}$ is a maximum capacity of the battery, $\Delta S$ is an amount of SOC change, k is a temperature coefficient, I is a current, and R is a resistance.

9. The method as claimed in claim 8, wherein the calculating of the first temperature comprises calculating, by the at least

$$k = \frac{dT}{I^2 \times (\frac{ESR}{p}) \times dt}$$

one processor, the temperature coefficient according to , wherein k is the temperature coefficient, dT is a temperature change, I is a current, p is a number of battery cells, dt is a time change, and ESR is an equivalent resistance.

10. The method as claimed in any one of the preceding claims, wherein the determining of the specific SOC associated with the discharge end point comprises:

   determining, by the at least one processor, based on the calculated plurality of temperatures, whether or not the temperature of the battery exceeds a threshold temperature before a voltage of the battery is equal to or lower than a final discharge voltage; and
   if the temperature of the battery is determined to exceed the threshold temperature before the voltage of the battery is equal to or lower than the final discharge voltage, determining, by the at least one processor, an SOC associated with the temperature exceeding the threshold temperature to be the specific SOC associated with the discharge end point.

11. The method as claimed in claim 10, wherein the determining of the change trend of the SOC comprises, if the SOC associated with the temperature exceeding the threshold temperature is determined to be the specific SOC associated with the discharge end point, determining, by the at least one processor, the change trend of the SOC so that a range of available SOCs is reduced.

12. The method as claimed in claim 10, wherein the determining of the change trend of the SOC comprises, if the SOC associated with the temperature exceeding the threshold temperature is determined to be the specific SOC associated with the discharge end point, determining, by the at least one processor, the change trend of the SOC so that an SOC change rate associated with the discharge is more rapid.

13. The method as claimed in claim 10, claim 11 or claim 12, wherein the determining of the SOC associated with the temperature exceeding the threshold temperature comprises:

   calculating, by the at least one processor, a plurality of voltages associated with the plurality of SOCs of the battery that are gradually downgraded from the calculated battery SOC by the grade;
   determining, by the at least one processor, based on the calculated voltages, an SOC associated with the final discharge voltage at which the voltage of the battery is equal to or lower than the final discharge voltage; and
   if the temperature of the battery is determined to not exceed the threshold temperature before the voltage of the battery is equal to or lower than the final discharge voltage, determining, by the at least one processor, the SOC associated with the final discharge voltage to be the specific SOC associated with the discharge end point.

14. A non-transitory computer-readable recording medium comprising instructions executable by the at least one processor to perform the method as claimed in any one of the preceding claims.

15. A battery management system comprising:

at least one processor; and

memory comprising at least one computer-readable program executable by the at least one processor to cause the at least one processor to:

calculate a state of charge (SOC) of a battery;

obtain a temperature of the battery;

calculate, based on the obtained temperature, a plurality of temperatures associated with a plurality of SOCs of the battery that are gradually downgraded from the calculated SOC of the battery by a grade;

determine, based on the calculated plurality of temperatures, a specific SOC associated with a discharge end point of the battery; and

determine, based on the determined specific SOC, a change trend of the SOC.

FIG. 1

Processor 140

210

Sensing data acquirer

220

Temperature change predictor

230

SOC Calculator

# FIG. 2

FIG. 3

FIG. 4

FIG. 5

FIG. 6

FIG. 7

800

# FIG. 8

```
                                    900
          ┌─────────────┐          ╱
          │    START    │        ╱
          └──────┬──────┘      ↙
                 │                    ┌S910
    ┌────────────▼─────────────────────────┐
    │            CALCULATE SOC              │
    └────────────┬─────────────────────────┘
                 │                    ┌S920
    ┌────────────▼─────────────────────────┐
    │      OBTAIN TEMPERATURE OF BATTERY    │
    └────────────┬─────────────────────────┘
                 │                    ┌S930
    ┌────────────▼─────────────────────────┐
    │ CALCULATE PLURALITY OF TEMPERATURES   │
    │ ASSOCIATED WITH PLURALITY OF BATTERY  │
    │ SOCS GRADUALLY DOWNGRADED FROM SOC OF │
    │ BATTERY, ON BASIS OF OBTAINED         │
    │ TEMPERATURE                           │
    └────────────┬─────────────────────────┘
                 │                    ┌S940
    ┌────────────▼─────────────────────────┐
    │ DETERMINE SPECIFIC SOC ASSOCIATED     │
    │ WITH DISCHARGE END POINT OF BATTERY,  │
    │ ON BASIS OF PLURALITY OF CALCULATED   │
    │ TEMPERATURES                          │
    └────────────┬─────────────────────────┘
                 │                    ┌S950
    ┌────────────▼─────────────────────────┐
    │ DETERMINE SOC CHANGE TREND ON BASIS   │
    │ OF DETERMINED SPECIFIC SOC            │
    └────────────┬─────────────────────────┘
                 │
          ┌──────▼──────┐
          │     END     │
          └─────────────┘
```

# FIG. 9

S930

S920

S1010
CALCULATE TEMPERATURE COEFFICIENT

S1020
DOWNGRADE SOC DETERMINED AT THE PRESENT TIME BY GRADE

S1030
CALCULATE TEMPERATURE OF DOWNGRADED SOC

S1040
DETERMINE
WHETHER OR NOT DOWNGRADED
SOC IS SOC HAVING LAST GRADE

no

yes

S1050
DETERMINE TEMPERATURE CHANGE TREND

S940

FIG. 10

Europäisches
Patentamt

European
Patent Office

Office européen
des brevets

# EUROPEAN SEARCH REPORT

**Application Number**

EP 24 18 6878

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | WO 2023/116524 A1 (GREAT WALL MOTOR CO LTD [CN]) 29 June 2023 (2023-06-29)<br>* figures *<br>* claims *<br>* paragraphs [0033] - [0071] *<br>& EP 4 455 697 A1 (GREAT WALL MOTOR CO LTD [CN]) 30 October 2024 (2024-10-30)<br>- - - - - | 1-15 | INV.<br>G01R31/367<br>G01R31/374<br>G01R31/382<br>G01R31/3835 |
| A | US 2014/055100 A1 (IGARASHI NAOYUKI [JP] ET AL) 27 February 2014 (2014-02-27)<br>* figures *<br>* claims *<br>* paragraphs [0018] - [0046] *<br>- - - - - | 1-15 | |
| A | US 2021/072321 A1 (BARSUKOV YEVGEN [US] ET AL) 11 March 2021 (2021-03-11)<br>* figures *<br>* claims *<br>* paragraphs [0012] - [0051] *<br>- - - - - | 1-15 | |
| | | | **TECHNICAL FIELDS SEARCHED (IPC)**<br><br>G01R<br>H01M |

The present search report has been drawn up for all claims

| Place of search | Date of completion of the search | Examiner |
|---|---|---|
| The Hague | 26 November 2024 | Moulara, Guilhem |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**ANNEX TO THE EUROPEAN SEARCH REPORT
ON EUROPEAN PATENT APPLICATION NO.**

EP 24 18 6878

This annex lists the patent family members relating to the patent documents cited in the above-mentioned European search report.
The members are as contained in the European Patent Office EDP file on
The European Patent Office is in no way liable for these particulars which are merely given for the purpose of information.

26-11-2024

| Patent document cited in search report | Publication date | Patent family member(s) | | Publication date |
|---|---|---|---|---|
| WO 2023116524 A1 | 29-06-2023 | CN | 115113070 A | 27-09-2022 |
| | | EP | 4455697 A1 | 30-10-2024 |
| | | WO | 2023116524 A1 | 29-06-2023 |
| US 2014055100 A1 | 27-02-2014 | CN | 103630843 A | 12-03-2014 |
| | | EP | 2700964 A2 | 26-02-2014 |
| | | JP | 5863603 B2 | 16-02-2016 |
| | | JP | 2014044074 A | 13-03-2014 |
| | | US | 2014055100 A1 | 27-02-2014 |
| US 2021072321 A1 | 11-03-2021 | CN | 103250066 A | 14-08-2013 |
| | | CN | 105005000 A | 28-10-2015 |
| | | JP | 6406825 B2 | 17-10-2018 |
| | | JP | 2014505863 A | 06-03-2014 |
| | | US | 2012143585 A1 | 07-06-2012 |
| | | US | 2016116543 A1 | 28-04-2016 |
| | | US | 2019137570 A1 | 09-05-2019 |
| | | US | 2021072321 A1 | 11-03-2021 |
| | | WO | 2012078599 A2 | 14-06-2012 |

EPO FORM P0459

For more details about this annex : see Official Journal of the European Patent Office, No. 12/82